# EUROPÄISCHE PATENTANMELDUNG

(11) **EP 0 677 695 A2**
(43) Veröffentlichungstag der Anmeldung: **18.10.1995**
(21) Anmeldenummer: 95105069.9
(22) Anmeldetag: 05.04.1995
(51) Int. Cl.: F21P 1/00, F21V 31/00

(54) **Beleuchtungseinrichtung, insbesondere Notbeleuchtungseinrichtung für das Innere von Wasserfahrzeugen**

(30) Priorität: 14.04.1994 DE 4412772
(71) Anmelder: airsigna GmbH + Co. KG, D-28307 Bremen (DE)
(72) Erfinder: Schilling, Horst Dieter, D-28327 Bremen (DE)
(74) Vertreter: Möller, Friedrich, Dipl.-Ing.

(57) **Zusammenfassung**

Herkömmliche Notbeleuchtungseinrichtungen bestehen aus starren Modulen mit elektrischen Steckverbindungen. Diese Module sind nicht feuchtigkeitsdicht ausgebildet. Daher muß beim Verlegen der Beleuchtungseinrichtung das Gehäuse abgedichtet werden.

Bei der erfindungsgemäßen Beleuchtungseinrichtung (10) ist der Träger (19) als flexible Trägerbahn ausgebildet. Dem Träger (19), Leuchtkörpern (18) und Leitern (20,21,22) ist eine feuchtigkeitsdichte Schutzhülle (25) zugeordnet. Die derart ausgebildete Beleuchtungseinrichtung (10) läßt sich mit besonders geringem Aufwand verlegen.

## Beschreibung

Die Erfindung betrifft eine Beleuchtungseinrichtung, insbesondere Notbeleuchtungseinrichtung für das Innere von Wasserfahrzeugen nach dem Oberbegriff der Ansprüche 1, 7, 10 und 13.

Beleuchtungseinrichtungen, insbesondere Notbeleuchtungseinrichtungen für das Innere von Wasserfahrzeugen, sollen im Falle einer Havarie, z.B. eines Feuers an Bord, den Passagieren den rettenden Weg zum Ausgang weisen. Sie werden in Bodennähe verlegt und müssen zur Wahrung der Funktionalität feuchtigkeitsdicht ausgebildet sein.

Derartige Beleuchtungseinrichtungen bestehen aus einer Beleuchtungseinheit und gegebenenfalls einem diese aufnehmenden Gehäuse. Die Beleuchtungseinheit umfaßt einen Träger, Leuchtkörper, Vorwiderstände und gegebenenfalls weitere elektrische bzw. elektronische Bauelemente.

Die Beleuchtungseinheit bisher bekannter Notbeleuchtungseinrichtungen besteht aus starren Modulen. Diese werden beim Verlegen ineinander gesteckt. Die starren Module lassen sich aufgrund der erforderlichen elektrischen Steckverbindungen nicht feuchtigkeitsdicht ausbilden und müssen demzufolge in einem dichten Gehäuse verlegt werden. Das Verlegen dieser Notbeleuchtungseinrichtungen ist mit hohem Aufwand verbunden. Desweiteren sind die elektrischen Steckverbindungen fehleranfällig. Die Systemzuverlässigkeit bekannter Notbeleuchtungseinrichtungen ist begrenzt. Ferner können aufgrund der Starrheit mit bekannten Notbeleuchtungseinrichtungen gekrümmte Strukturen nicht oder nur mit großem Aufwand ausgestattet werden.

Desweiteren weisen bekannte Notbeleuchtungseinrichtungen für das Innere von Wasserfahrzeugen den Nachteil auf, daß zur funktionsgerechten Ausleuchtung z.B. eines Fluchtweges an einer Stelle mehrere Leuchtkörper miteinander kombiniert werden müssen, die unterschiedlich zur Modulnormalen ausgerichtet sind. Dies ist fertigungstechnisch besonders aufwendig.

Ausgehend von den bekannten Beleuchtungseinrichtungen liegt der Erfindung die Aufgabe zugrunde, eine Beleuchtungseinrichtungen zu schaffen, die zuverlässig ist und mit geringem Aufwand verlegt sowie gefertigt werden kann.

Zur Lösung dieser Aufgabe weist die erfindungsgemäße Beleuchtungseinrichtung die Merkmale des Anspruchs 1 auf. Dies hat den Vorteil, daß die Beleuchtungseinheit biegefähig ausgebildet ist. Gekrümmte Strukturen können mit dieser auf einfache Weise ausgestattet werden. Sie läßt sich zudem endlos verlegen. Die Beleuchtungseinheit kann außerdem durch einfaches Einschieben in bereits vorhandene Gehäuse eingebracht werden.

Vorzugsweise sind mindestens Leuchtkörper und Leiter feuchtigkeitsdicht auf der Trägerbahn angeordnet. Dies hat den Vorteil, daß die Beleuchtungseinheit an sich bereits feuchtigkeitsdicht ist. Das Gehäuse, in dem die Beleuchtungseinheit verlegt wird, muß nicht feuchtigkeitsdicht ausgebildet sein.

Nach einer vorteilhaften Ausgestaltung der erfindungsgemäßen Beleuchtungseinrichtung weist diese die Merkmale des Anspruchs 9 auf. Die Beleuchtungseinrichtung kann ohne fehleranfällige Steckverbindungen auf einfache Weise und mit geringem Aufwand verlegt werden.

Nach einer weiteren vorteilhaften Ausgestaltung der Erfindung weist die Beleuchtungseinrichtung die Merkmale des Anspruchs 13 auf. Das oder jedes Piktogramm ist in demselben Gehäuse wie Leuchtkörper und/oder Leiter angeordnet. Diese Ausgestaltung sorgt ebenfalls dafür, daß die Beleuchtungseinrichtung mit geringem Aufwand verlegt werden kann und kein separates Gehäuse für das oder jedes Piktogramm erforderlich ist.

Nach einer weiteren vorteilhaften Ausgestaltung der Erfindung weist die Beleuchtungseinrichtung die Merkmale des Anspruchs 16 auf. Durch Verwendung von Leuchtkörpern mit einem großen Abstrahlwinkel kann auf die fertigungstechnisch aufwendige Kombination mehrerer Dioden an einer Stelle der Beleuchtungseinrichtung bzw. Beleuchtungseinheit verzichtet werden. Das von jedem einzelnen Leuchtkörper emitierte Licht ist aus praktisch allen Richtungen deutlich erkennbar, und es ergibt sich eine hervorragende Sichtbarkeit. Diese Eigenschaft ist besonders bei kleinen Betrachtungswinkeln gegenüber einer Horizontalen wichtig, da sich bei einer starken Rauchentwicklung die flüchtenden Personen meist in Bodennähe aufhalten.

Bevorzugte Weiterbildungen der Erfindung ergeben sich aus den Unteransprüchen und der Beschreibung. Nachfolgend werden Ausführungsbeispiele der Erfindung an der Zeichnung näher erläutert. In der Zeichnung zeigen:
- Fig. 1: eine Beleuchtungseinrichtung im Querschnitt,
- Fig. 2: eine Beleuchtungseinheit im Längsschnitt,
- Fig. 3: ein Layout für die Leiteranordnung einer Struktur,
- Fig. 4: eine Bestückung der Struktur gemäß Fig. 3 nach einem ersten Ausführungsbeispiel der Erfindung,
- Fig. 5: eine Bestückung der Struktur der Fig. 3 nach einem zweiten Ausführungsbeispiel der Erfindung,
- Fig. 6: einen Ausschnitt aus der Beleuchtungseinheit in Draufsicht nach einem ersten Ausführungsbeispiel der Erfindung,
- Fig. 7: einen Ausschnitt aus der Beleuchtungseinheit nach einem zweiten Ausführungsbeispiel der Erfindung in einer Ansicht ananlog zu Fig. 6,
- Fig. 8: ein Ersatzschaltbild für eine Leuchtkörpergruppe, und
- Fig. 9: ein Ersatzschaltbild für die erfindungsgemäße Beleuchtungseinrichtung.

Die in der Zeichnung dargestellte Beleuchtungseinrichtung dient als Notbeleuchtungseinrichtung für das Innere von Wasserfahrzeugen. Diese wird in Bodennähe oder auf dem Boden verlegt.

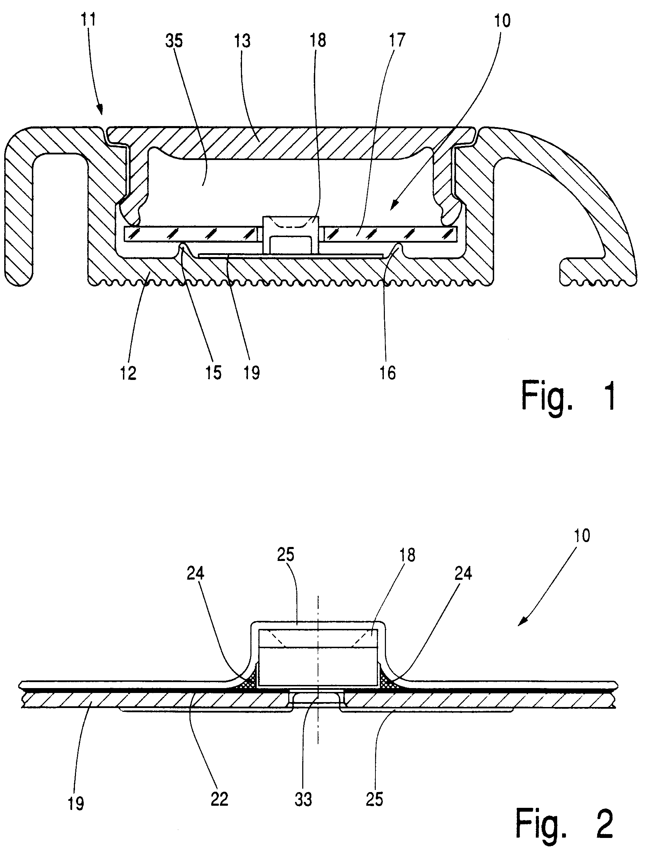

Die in Fig. 1 dargestellte Beleuchtungseinrichtung besteht aus einer in einem Gehäuse 11 angeordneten Beleuchtungseinheit 10.. Das Gehäuse 11 besteht aus einem Profil 12 und einer Abdeckung 13. Das Profil 12 besteht vorzugsweise aus Aluminium, die Abdeckung 13 aus durchsichtigem Material.

Ein Bodenstück 14 des Profils 12 verfügt über zwei im Abstand zueinander angeordnete, sich in Längsrichtung des Profils 12 erstreckende Leisten 15, 16, zwischen denen die Beleuchtungseinheit 10 in einer gewünschten Position fixiert wird. Auf den Leisten 15, 16 stützt sich eine Abdeckfolie 17 ab, die die Beleuchtungseinheit 10 teilweise, nämlich außerhalb des Bereichs von Leuchtkörpern 18, abdeckt. Die Abdeckfolie 17 unterstützt zusammen mit der eingerasteten Abdeckung 13 die Fixierung der in das Profil 12 eingelegten Beleuchtungseinheit 10. Eine weitere Befestigung durch z.B. Klebestreifen ist nicht notwendig. Die Abdeckfolie 17 kann beliebig eingefärbt werden und deckt die Beleuchtungseinheit 10 dekorativ ab.

Die Beleuchtungseinheit 10 besteht aus einem Träger 19 und auf diesen aufgebrachten elektrischen Leitern, nämlich zwei durchgehenden Versorgungsleitern 20, 21 und einem Mittelleiter 22. Der Träger 19 ist als durchgehende, flexible, biegsame Trägerbahn ausgebildet, so z.B. aus einer Polyimid-Folie. Die Folie der Trägerbahn verfügt über eine Stärke von ca. 50 µm. Auf der Einheit aus Träger 19, Versorgungsleitern 20, 21 und Mittelleiter 22 sind Leuchtkörper 18 aufgebracht. Die Leuchtkörper 18 sind als Lumineszenzdioden (LEDs) ausgebildet. Zusätzlich zu den Leuchtkörpern 18 sind Vorwiderstände 23 auf den Träger aufgebracht. Leuchtkörper 18 und Vorwiderstände 23 werden maschinell im SMD-Technik auf den Träger aufgebracht und mit diesem zu einem monolithischen Block verlötet (Lötstellen 24). Dieser monolithische Block ist allseitig von einem feuchtigkeitsdichten Schutzüberzug 25 überzogen. Der Schutzüberzug 25 ist hoch transparent und flexibel. Vorzugsweise wird als Schutzüberzug 25 ein Silikon-Schutzlack oder auch eine Schutzbeschichtung mit Poly-Para-Xylylene verwendet. Der Schutzüberzug 25 wird auf den monolithischen Block aus Träger 19, Leitern 20..22 und Vorwiderständen 23 aufgedampft. Der Schutzüberzug 25 besitzt eine Stärke von 25 µm bis 40 µm. Alternativ ist es möglich, daß der Schutzüberzug 25 nur teilweise, nämlich im Bereich der elektrischen bzw. elektronischen Baugruppen auf den monolithischen Block aufgebracht ist.

Die Beleuchtungseinheit 10 ist demzufolge für sich feuchtigkeitsdicht. Bei Verlegung der Beleuchtungseinheit 10 im Gehäuse 11 muß dieses an den Verbindungsstellen zwischen Profil 12 und Abdeckung 13 nicht abgedichtet sein.

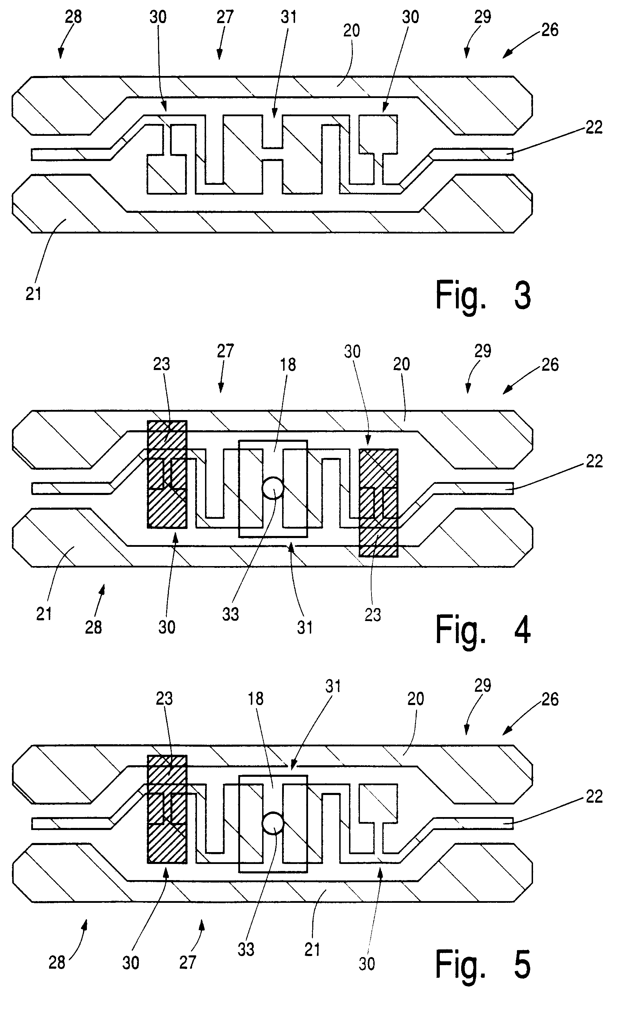

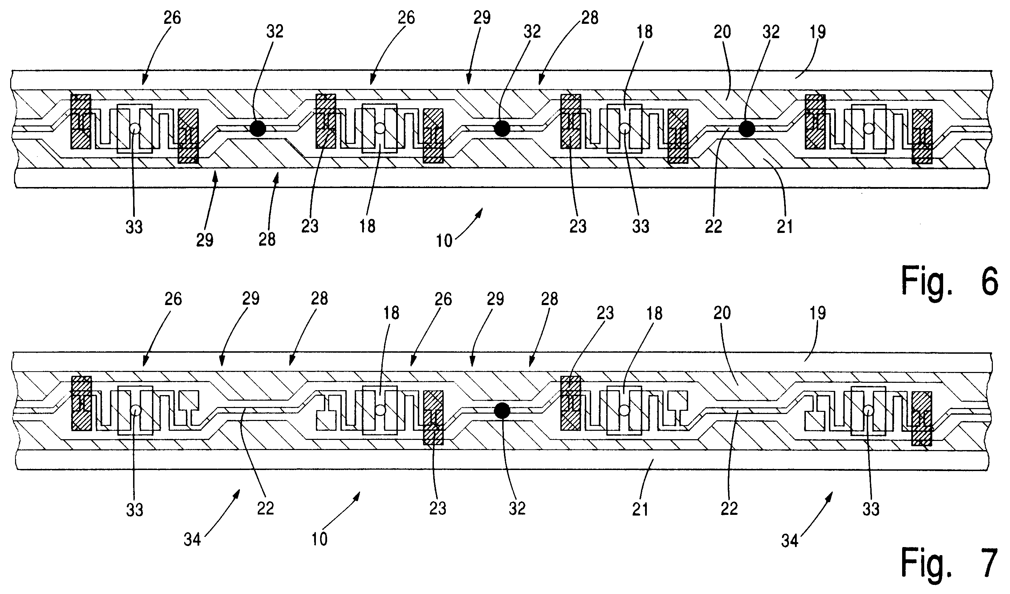

Das in Fig. 3 dargestellte Layout für die Versorgungsleiter 20, 21 und Mittelleiter 22 besteht aus sich zyklisch wiederholenden und nahtlos ineinander übergehenden Strukturen 26. Ein Mittelbereich 27 der Struktur 26 dient der Anbringung der Leuchtkörper 18 und Vorwiderstände 23, die Überlappungsbereiche 28, 29 dienen der überlappenden Aneinanderreihung einzelner Strukturen 26. Durch die in den Fig. 6 und 7 gezeigte überlappende Anordnung der Strukturen 26 entstehen durchgehende Versorgungsleiterbahnen 20, 21 und Mittelleiter 22.

Das stets gleiche Layout der auf den Träger 19 aufgebrachten Leiter 20..22 einer Struktur 26 kann je nach gewünschter Beschaltung der gesamten Beleuchtungseinheit 10 auf unterschiedliche Weise mit Leuchtkörpern 18 bzw. Vorwiderständen 23 bestückt werden. Hierzu verfügt der Mittelleiter 22 im Mittelbereich 27 über Bereiche 30 zur Anordnung der Vorwiderstände 23 und über einen Bereich 31 zur Anordnung des Leuchtkörpers 18. Fig. 4 zeigt eine mit zwei Vorwiderständen 23 und einem Beleuchtungskörper 18 bestückte Struktur 26. Bei überlappender Anordnung mehrerer Strukturen 26 wird bei Verwendung der in Fig. 4 gezeigten Struktur 26 eine Beleuchtungseinrichtung 10 geschaffen, bei der die Beleuchtungskörper 18 alle parallel geschaltet angeorndet sind (Fig. 6). Hierzu muß in den Überlappungsbereichen 28, 29 der Mittelleiter 22 unterbrochen werden. Diesbezüglich wird der Mittelleiter 22 in den Überlappungsbereichen 28, 29 mit Ausstanzungen 32 versehen. Im Bereich 31 des aufzubringenden Leuchtkörpers 18 wird der Mittelleiter 22 aus schaltungstechnischen Gründen ebenfalls mit einer Ausstanzung 33 versehen.

Fig. 5 zeigt eine weitere mögliche Bestückung der Struktur 26. In diesem Falle ist die Struktur 26 nur in einem Bereich 30 mit einem Vorwiderstand bestückt. Der andere Bereich 30 des Mittelleiters bleibt frei. Im Bereich 31 ist auf die Struktur 26 ein Leuchtkörper 18 aufgebracht. Eine derartige Bestückung der Struktur 26 ist dann von Interesse, wenn mehrere Leuchtkörper 18 in Serie zu einer Leuchtkörpergruppe 34 verschaltet werden sollen. Fig. 7 zeigt eine Beleuchtungseinheit 10 aus parallel geschalteten Leuchtkörpergruppen 34, wobei jede Leuchtkörpergruppe 34 aus zwei in Serie geschalteten Leuchtkörpern 18 besteht. Jede Leuchtkörpergruppe 34 wird von zwei Vorwiderständen 23 begrenzt. Zwischen den Leuchtkörpern 18 einer Leuchtkörpergruppe 34 sind keine weiteren Widerstände vorgesehen. Im Bereich einer Leuchtkörpergruppe 34 sind Ausstanzungen 33 nur im Bereich der auf dem Mittelleiter 22 angeordneten Leuchtkörper 18 vorgesehen. Ausstanzungen 32 des Mittelleiters 22 in den Überlappungsbereichen 28,29 sind nur zur Trennung und damit Parallelschaltung der einzelnen Leuchtkörpergruppen 34 vorgesehen.

Die Leuchtkörper sind als Lumineszenzdioden (LEDs) ausgebildet. Es sind LEDs mit einem Abstrahlwinkel von vorzugsweise 120^{o} vorgesehen. Dies sorgt auch bei einer geringen Anzahl von Leuchtdioden für eine hervorragende Sichtbarkeit des von den LEDS emitierten Lichts aus praktisch allen Richtungen. Die gute Sichtbarkeit des von den LEDs emitierten Lichts wird durch die Abdeckung 13 verstärkt. Die Abdeckung 13 aus gut durchscheinendem, vorzugsweise glasklarem Material verfügt über einen Brechungsindex größer 1, vorzugsweise 1,55. Demzufolge wird die virtuelle Strahlungsquelle für den Beobachter deutlich nach oben verschoben.

Die Abdeckung 13 ist ebenso wie die Beleuchtungseinheit 10 und die Abdeckfolie 17 aus elastischem, flexiblem Material ausgebildet. Dies gewährleistet eine besonders einfache Verlegung der Beleuchtungseinrichtung ohne Nahtstellen.

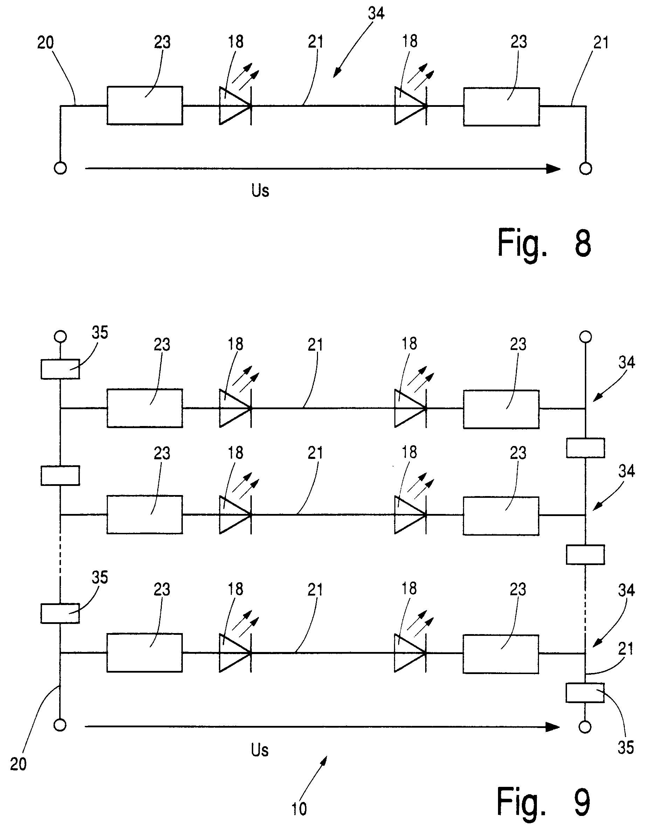

Die elektrische Struktur der Beleuchtungseinheit 10 wird im folgenden anhand der Ersatzschaltbilder gemäß Fig. 8 und 9 erörtert. Fig. 8 zeigt ein Ersatzschaltbild für eine Leuchtkörpergruppe 34, die nach dem Ausführungsbeispiel gemäß Fig. 7 aus zwei in Serie geschalteten Leuchtkörpern 18 besteht. Mehrere parallel geschaltete Leuchtkörpergruppen 34 bilden die Beleuchtungseinheit 10.

Die mögliche Anzahl der Leuchtkörper 18 pro Leuchtkörpergruppe 34 hängt von der gewählten Betriebsspannung US, dem gewählten Arbeitspunkt der LEDs und dem gewünschten Wirkungsgrad der Beleuchtungseinrichtung bzw. Beleuchtungseinheit ab. Bei der Parallelschaltung mehrerer Leuchtkörpergruppen 34 zu einer Beleuchtungseinheit 10 muß der Bahnwiderstand 35 der Versorgungsleiter 20, 21 mit berücksichtigt werden. Die Bahrwiderstände 35 verursachen Energieverluste und bewirken einen Lichtstärkeabfall der Leuchtkörper 18. Dennoch hat sich gezeigt, daß nahezu endlose Beleuchtungseinrichtungen nach dem oben erörterten Konstruktionsprinzip geschaffen werden können.

Versorgungsleiter 20, 21 und Mittelleiter 22 sind im nichtbestückten Zustand durchgehend, d.h. ohne Unterbrechung ausgebildet. Dadurch lassen sich die Leiter 20..22 galvanisieren, und mit einer durchgehenden Nickel- bzw. Goldschicht versehen.

Der Beleuchtungseinrichtung sind in der Zeichnung nicht dargestellte Piktogramme zugeornet. Erfindungsgemäß sind die Piktogramme in demselben Gehäuse 11 wie die Beleuchtungseinheit 10 angeordnet. Aufgrund der flachen Ausgestaltung der Beleuchtungseinheit 10 ist es möglich, in dem Freiraum 36 zwischen Abdeckfolie 17 bzw. Beleuchtungseinheit 10 und Abdeckung 13 des Gehäuses 11 das Piktogramm anzuordnen. Das Piktogramm überdeckt in eingebautem Zustand die Beleuchtungseinheit 10.

Die Beleuchtungseinrichtung wird am Boden oder in Bodennähe verlegt. Das Gehäuse 11 zur Aufnahme der Beleuchtungseinheit 10 kann einerseits als Fußleiste ausgebildet sein, andererseits kann das Gehäuse 11 flächig in den Boden integriert werden.

Zum Schutz vor Beschädigungen ist das Gehäuse 11 bruchsicher ausgebildet. Die Abdeckung 13 des Gehäuses 11 ist zudem auch kratzfest.

Desweiteren kann die Beleuchtungseinheit 10 auch ohne Gehäuse 11 verlegt werden. In diesem Fall sind die Begriffe Beleuchtungseinheit und Beleuchtungseinrichtung gleichbedeutend.

## Patentansprüche

1. Beleuchtungseinrichtung, insbesondere Notbeleuchtungseinrichtung für das Innere von Wasserfahrzeugen, mit in Abständen zueinander auf einem Träger angeordneten und durch elektrische Leiter verbundenen Leuchtkörpern, dadurch gekennzeichnet, daß der Träger (19) als eine flexible Trägerbahn ausgebildet ist.

2. Beleuchtungseinrichtung nach Anspruch 1, dadurch gekennzeichnet, daß Leuchtkörper (18) und Leiter (Versorgungsleiter 20, 21; Mittelleiter 22) flüssigkeitsdicht auf dem Träger (19) angeordnet sind.

3. Beleuchtungseinrichtung nach Anspruch 1 oder 2, dadurch gekennzeichnet, daß dem Träger (19), den Leuchtkörpern (18), den Leitern (20, 21, 22) und gegebenenfalls weiteren elektrischen Bateilen ein feuchtigkeitsdichter Schutzüberzug (25) zugeordnet ist.

4. Beleuchtungseinrichtung nach einem oder mehreren der vorgehenden Ansprüche, dadurch gekennzeichnet, daß die Leuchtkörper (18) auf dem Träger (19) in Reihen- und/oder Parallelschaltung angeordnet sind, wobei vorzugsweise einer Leuchtkörpergruppe (34) mindestens zwei in Reihe geschaltete Leuchtkörper (18) zugeordnet sind und mindestens zwei Leuchtkörpergruppen (34) in Parallelschaltung angeordnet sind.

5. Beleuchtungseinrichtung nach einem oder mehreren der Ansprüche 1 bis 4, dadurch gekennzeichnet, daß jedem Leuchtkörper (18) oder jeder Leuchtkörpergruppe (34) mindestens ein Vorwiderstand (23) zugeordnet ist.

6. Beleuchtungseinrichtung nach einem oder mehreren der Ansprüche 1 bis 5, dadurch gekennzeichnet, daß einem Leuchtkörper (18) und/oder Vorwiderstände (23) verbindenden Mittelleiter (22) Ausstanzungen (32, 33) zugeordnet sind.

7. Beleuchtungseinrichtung, insbesondere Notbeleuchtungseinrichtung für das Innere von Wasserfahrzeugen, mit in Abständen zueinander auf einem Träger angeordneten, durch elektrische Leiter verbundenen Leuchtkörpern, wobei der Träger mit den Leuchtkörpern in einem Gehäuse angeordnet ist, insbesondere nach einem oder mehreren der Ansprüche 1 bis 6, dadurch gekennzeichnet, daß der Träger (19) im Gehäuse (11) endlos angeordnet ist.

8. Beleuchtungseinrichtung nach Anspruch 7, dadurch gekennzeichnet, daß dem Träger (19) eine Halte- und/oder Abdeckfolie (17) zugeordnet ist und/oder dem Gehäuse (11) einen durchscheinende, insbesondere eine durchsichtige, Abdeckung (13) zugeordnet ist.

9. Beleuchtungseinrichtung nach Anspruch 7 oder 8, dadurch gekennzeichnet, daß das Gehäuse (11) als Fußleiste oder dergleichen ausgebildet ist.

10. Beleuchtungseinrichtung, insbesondere Notbeleuchtungseinrichtung für das Innere von Wasserfahrzeugen, mit in Abständen zueinander auf einem Träger angeordneten, durch elektrische Leiter verbundenen Leuchtkörpern, und mit einem oder mehreren Piktogrammen, insbesondere nach einem oder mehreren der Ansprüche 1 bis 9, dadurch gekennzeichnet, daß das oder jedes Piktogramm zusammen mit den Leuchtkörpern (18) und/oder dem Träger (19) in einem gemeinsamen Gehäuse angeordnet ist.

11. Beleuchtungseinrichtung nach Anspruch 10, dadurch gekennzeichnet, daß das oder jedes Piktogramm derart in dem Gehäuse (11) angeordnet ist, daß die dahinter liegenden Leuchtkörper (18) und Leiter (20..22) unsichtbar sind.

12. Beleuchtungseinrichtung nach Anspruch 10 oder 11, dadurch gekennzeichnet, daß Träger (19), Leuchtkörper (18) und Leiter (20..22) von dem oder jedem Piktogramm überdeckt sind.

13. Beleuchtungseinrichtung, insbesondere Notbeleuchtungseinrichtung für das Innere von Wasserfahrzeugen, mit in Abständen zueinander, auf einem Träger angeordneten und durch elektrische Leiter verbundenen Leuchtkörpern, insbesondere nach einem oder mehreren der Ansprüche 1 bis 12, dadurch gekennzeichnet, daß die Leuchtkörper (18) einen Abstrahlwinkel von 100^{o} bis zu 140^{o} aufweisen.

14. Beleuchtungseinrichtung nach Anspruch 13, dadurch gekennzeichnet, daß die Leuchtkörper (18) einen Abstrahlwinkel von vorzugsweise 120^{o} aufweisen und als Leuchtdioden (LEDs) ausgebildet sind, die einen Abstand von 10 bis 40 cm, vorzugsweise 20 cm, aufweisen.

15. Beleuchtungseinrichtung nach Anspruch 13 oder 14, dadurch gekennzeichnet, daß der Träger (19) mit den Leuchtkörpern (18) in einem eine Abdeckung (13) aufweisenden Gehäuse (11) angeordnet sind, wobei die Abdeckung einen Brechungsindex von größer 1 aufweist.
